# EUROPÄISCHE PATENTANMELDUNG

(11) **EP 3 174 207 A1**
(43) Veröffentlichungstag der Anmeldung: **31.05.2017**
(21) Anmeldenummer: 15195950.9
(22) Anmeldetag: 24.11.2015
(51) Int. Cl.: H03K 17/74, G05B 19/042, H02H 11/00, H03K 17/06

(54) **DIGITALAUSGABEBAUGRUPPE UND AUTOMATISIERUNGSSYSTEM MIT EINER DIGITALAUSGABEBAUGRUPPE**

(71) Anmelder: Siemens Aktiengesellschaft, 80333 München (DE)
(72) Erfinder: Briemle, Thomas, 92245 Kümmersbruck (DE); Eckl, Wolfgang, 91207 Lauf (DE); Engl, Werner, 92706 Luhe-Wildenau (DE); Grosser, Stefan, 92253 Schnaittenbach (DE); Grünewald, Uwe, 90559 Burgthann (DE); Weikert, Robert, 92342 Burggriesbach (DE)

(57) **Zusammenfassung**

Die Erfindung betrifft eine Digitalausgabebaugruppe (1) zur Ausgabe digitaler Signale über einen Ansteuerausgang (2) für die Ansteuerung einer Last (L), umfassend einen Versorgungsspannungsanschluss (P24) und einen ersten Masseanschluss (M1) zum Anschließen einer Spannungsquelle (V1), welche zum einen einen Laststrom für die Last (L) bereitstellt und zum anderen eine Spannungsversorgung für eine Steuerlogik (10) bereitstellt, welche ausgestaltet ist ein Halbleiterschaltmittel (11) zu steuern, und das Halbleiterschaltmittel (11) zur Ansteuerung der Last (L) über den Ansteuerausgang (2) einen ersten Halbleiterschalter (V20) für die Ausgabe eines High-Pegels und einen zweiten Halbleiterschalter (V21) für die Ausgabe eines Low-Pegels aufweist, wobei zwischen dem zweiten Halbleiterschalter (V21) und dem Ansteuerausgang (2) eine Sperrdiode (V22) angeordnet ist, um für den Fall, einer angeschlossenen Last (L) und das ein Low-Pegel am Ansteuerausgang (2) vorherrschen soll, aber aufgrund einer Unterbrechung der über den ersten Masseanschluss (M) hergestellten Masseverbindung zur Spannungsquelle (V1), einen Stromfluss (I_{MB}), ausgehend von der Spannungsquelle (V1) zu dem Versorgungsspannungsanschluss (P24) über die Steuerlogik (10) und über den zweiten Halbleiterschalter (V21) zu dem Ansteuerausgang (2) und weiter über die Last (L) zu einem zentralen Massepunkt (Z_{M}), mit welchem auch die Spannungsquelle (V1) in Verbindung steht, zu unterdrücken.

## Beschreibung

Die Erfindung betrifft eine Digitalausgabebaugruppe zur Ausgabe digitaler Signale über einen Ansteuerausgang für die Ansteuerung einer Last, umfassend einen Versorgungsspannungsanschluss und einen Masseanschluss zum Anschließen einer Spannungsquelle für die Baugruppe, welche einen Laststrom für die Last bereitstellt, eine Steuerlogik, welche ausgestaltet ist, ein Halbleiterschaltmittel zu steuern, und das Halbleiterschaltmittel zur Ansteuerung der Last über den Ansteuerausgang einen ersten Halbleiterschalter für die Ausgabe eines High-Pegels und einen zweiten Halbleiterschalter für die Ausgabe eines Low-Pegels aufweist.

Des Weiteren betrifft die Erfindung ein Automatisierungssystem aufweisend eine Spannungsquelle, eine Automatisierungssteuerung, eine Digitalausgabebaugruppe, und eine Last, wobei die Automatisierungssteuerung ausgestaltet ist, der Digitalausgabebaugruppe zur Ausgabe digitaler Signale über einen Ansteuerausgang für die Ansteuerung der Last einen Steuerbefehl mitzuteilen.

Aus dem Stand der Technik sind Digitalausgabebaugruppen und der Einsatz in Automatisierungssystemen bekannt. Aus dem Datenblatt von Phoenix Contact, IB IL 24 DO 4 ..., Inline-Klemme mit vier digitalen Ausgängen, AUTOMATIONWORX, Datenblatt 5557_de_05, Ausgabe 01/2007 ist eine Digitalausgabebaugruppe bekannt.

Aus dem Datenblatt AB-ASI-M12-DI4D04-M8-1A (22260759), gültig ab: 05/2009, ist von der Lapp Group die Digitalausgabebaugruppe Automation Bus AS-I-M8-Gerät mit vier digitalen Eingängen und vier digitalen Ausgängen bekannt.

Aus dem Datenblatt der PMA-Prozess- und Maschinen-Automations GmbH für eine Digitalausgabebaugruppe ist die VARIO DO 4/24, I/O-Erweiterungsmodul mit vier digitalen Ausgängen (02/2003) bekannt.

All die bisher bekannten Digitalausgabebaugruppen haben ein gemeinsames Problem, bei einen Massebruch einer Masseleitung zu der Digitalausgabebaugruppe kann am Ausgang noch ein Strom von bis zu 25 mA fließen. Bei einem Massebruch kann so ein ungewolltes Verhalten auftreten, da an einem Digitalausgang Strom fließt, obwohl der Digitalausgang abgeschaltet sein soll. Wenn an einem Digitalausgang z.B. ein Digitaleingang angeschlossen ist, erkennt dieser bereits ab 2 mA schon einen High-Pegel. Dies kann zu ungewollten Fehlerfällen bei einem Massebruch einer Masseleitung zu der Digitalausgabebaugruppe in einer Industrieanlage führen.

Bei der bekannten Digitalausgabebaugruppe von Phoenix ist in dem Datenblatt auf Seite 4, ein Ausgangsstrom bei Massebruch von maximal 25 mA beschrieben, bei der bekannten Digitalausgabebaugruppe der Lapp-Automation ist in dem Datenblatt auf Seite 4 ein Ausgangsstrom bei Massebruch im ausgeschalteten Zustand von maximal 5 mA und bei der Digitalausgabebaugruppe der PMA Prozess- und Maschinenautomation ist in dem Datenblatt auf Seite 9 ein Ausgangsstrom bei Massebruch von maximal 25 mA beschrieben.

Bei einer dem Anmelder bekannten Digitalausgabebaugruppe sind zwei Masseanschlussklemmen realisiert, welche beide angeschlossen werden sollen. Falls einer der beiden Masseanschlüsse bricht, bleibt die Funktion der Digitalausgabebaugruppe erhalten, aber brechen beide Masseanschlüsse, fließt ebenfalls wieder ein ungewollter Strom bei Ausgabe eines Low-Pegels über die Last.

Das bedeutet, eine wirkliche Lösung wurde immer noch nicht erreicht, wenn an beiden Masseanschlüssen jeweils gleichzeitig ein Drahtbruch auftritt, fließt der Versorgungsstrom wieder über den Ausgang ab. In der Praxis wird ein Auftreten dieses Problems nur unwahrscheinlicher, da beide Masseanschlüsse unterbrochen sein müssen, aber eine wirkliche Lösung stellt dies nicht dar.

Es ist Aufgabe der vorliegenden Erfindung die bekannten Digitalausgabebaugruppen dahingehend zu erweitern, dass bei einem Massebruch bei einem abgeschalteten Digitalausgang, also einer Low-Pegel-Ansteuerung, über den Ansteuerausgang für eine Last kein Strom fließt.

Die der Erfindung zugrundeliegende Aufgabe wird dadurch gelöst, dass die Digitalausgabebaugruppe zur Ausgabe digitaler Signale über einen Ansteuerausgang für die Ansteuerung einer Last folgende Merkmale umfasst, einen Versorgungsspannungsanschluss und einen ersten Masseanschluss zum Anschließen einer Spannungsquelle, welche zum einen einen Laststrom für die Last bereitstellt und zum anderen eine Spannungsversorgung für eine Steuerlogik bereitstellt, welche ausgestaltet ist, ein Halbleiterschaltmittel zu steuern, und das Halbleiterschaltmittel zur Ansteuerung der Last über den Ansteuerausgang einen ersten Halbleiterschalter für die Ausgabe eines High-Pegels und einen zweiten Halbleiterschalter für die Ausgabe eines Low-Pegels aufweist, wobei zwischen dem zweiten Halbleiterschalter und dem Ansteuerausgang eine Sperrdiode angeordnet ist, um für den Fall, einer angeschlossene Last und das ein Low-Pegel am Ansteuerausgang vorherrschen soll, aber aufgrund einer Unterbrechung der über den ersten Masseanschluss hergestellten Masseverbindung zur Spannungsquelle, einen Stromfluss, ausgehend von der Spannungsquelle zu dem Versorgungsspannungsanschluss über die Steuerlogik und über den zweiten Halbleiterschalter zu dem Ansteuerausgang und weiter über die Last zu einen zentralen Massepunkt, mit welchem auch die Spannungsquelle in Verbindung steht, zu unterdrücken. Die Sperrdiode zwischen dem zweiten Halbleiterschalter und dem Ansteuerausgang verhindert einen Stromfluss bei einer Low-Pegel Ausgabe und zufällig aufgetretenem Massebruch.

Im Hinblick auf induktive Lasten weist eine Weiterbildung der Digitalausgabebaugruppe einen zweiten Masseanschluss auf, welcher über die Spannungsquelle mit dem zentralen Massepunkt verbunden ist, und der zweite Masseanschluss über eine Freilaufdiode mit dem Ansteuerausgang in Verbindung steht, wobei die Freilaufdiode bei einen Low-Pegel am Ansteuerausgang für den Fall einer induktiven Last in Durchlassrichtung betrieben wird. Mit Vorteil können nun induktive Lasten beim Abschalten über die nun vorhandene Freilaufdiode gelöscht werden. Der Ausgang kann damit für Pulsweitenmodulation von induktiven Lasten genutzt werden.

Bei einer Ausgestaltung der Digitalausgabebaugruppe mit diskreten Elektronikbauteilen bezogen auf das Halbleiterschaltmittel ist die Digitalausgabebaugruppe wie folgt ausgestaltet. Der erste Halbleiterschalter ist mit einem Source-Anschluss an dem Versorgungsspannungsanschluss und der zweite Halbleiterschalter ist mit einem Drain-Anschluss an dem ersten Masseanschluss angeschlossen, ein Drain-Anschluss des ersten Halbleiterschalters und ein Source-Anschluss des zweiten Halbleiterschalters ist über die Sperrdiode an dem Ansteuerausgang angeschlossen, und ein erster Steuerausgang ist an einem Gate-Anschluss des ersten Halbleiterschalters angeschlossen und ein zweiter Steuereingang ist an einem Gate-Anschluss des zweiten Halbleiterschalters angeschlossen, wobei die Steuerlogik derart ausgestaltet ist, dass sie einen über einen Steuereingang kommenden Schaltbefehl zu Ansteuerung des Ansteuerausgangs mit einem High-Pegel oder einem Low-Pegel umsetzt, wobei für einen High-Pegel der erste Steuerausgang den Gate-Anschluss des ersten Halbleiterschalters ansteuert und für einen Low-Pegel der zweite Steuerausgang den Gate-Anschluss des zweiten Halbleiterschalters ansteuert.

Die eingangs genannte Aufgabe wird ebenfalls durch ein Automatisierungssystem gelöst, wobei das Automatisierungssystem folgende Merkmale aufweist, eine Spannungsquelle, eine Automatisierungssteuerung, eine Digitalausgabebaugruppe, eine Last, wobei die Automatisierungssteuerung ausgestaltet ist, der Digitalausgabebaugruppe zur Ausgabe digitaler Signale über einen Ansteuerausgang für die Ansteuerung der Last einen Steuerbefehl mitzuteilen, die Digitalausgabebaugruppe ist über einen Versorgungsspannungsanschluss und einen ersten Masseanschluss an der Spannungsquelle angeschlossen, die Last ist zum einen an dem Ansteuerausgang und zum anderen an einen zentralen Massepunkt angeschlossen, die Digitalausgabebaugruppe weist weiterhin eine Steuerlogik und ein Halbleiterschaltmittel auf, wobei die Steuerlogik ausgestaltet ist, das Halbleiterschaltmittel zu steuern, und das Halbleiterschaltmittel ist wiederum ausgestaltet, mit einem ersten Halbleiterschalter für die Ausgabe eines High-Pegels und einem zweiten Halbleiterschalter für die Ausgabe eines Low-Pegels, wobei zwischen dem zweiten Halbleiterschalter und dem Ansteuerausgang eine Sperrdiode angeordnet ist, um für den Fall, einer angeschlossenen Last und das ein Low-Pegel am Ansteuerausgang vorherrschen soll, aber aufgrund einer Unterbrechung der über den ersten Masseanschluss hergestellten Masseverbindung zur Spannungsquelle, einen Stromfluss, ausgehend von der Spannungsquelle zu dem Versorgungsspannungsanschluss über die Steuerlogik und über den zweiten Halbleiterschalter zu dem Ansteuerausgang und weiter über die Last zu einem zentralen Massepunkt, mit welchem auch die Spannungsquelle in Verbindung steht, zu unterdrücken.

Im Hinblick auf das Löschen von induktiven Lasten, ist in einer Weiterbildung die Digitalausgabebaugruppe mit einen zweiten Masseanschluss versehen, welcher über die Spannungsquelle mit den zentralen Massepunkt verbunden ist, und der zweite Masseanschluss über eine Freilaufdiode mit dem Ansteuerausgang in Verbindung steht, wobei die Freilaufdiode bei einem Low-Pegel am Ansteuerausgang für den Fall einer induktiven Last in Durchlassrichtung betrieben wird.

Anhand von den in der Zeichnung dargestellten Ausführungsbeispiel soll die Erfindung sowie vorteilhafte Ausgestaltungen, Verbesserungen und weitere Vorteile der Erfindung näher erläutert und beschrieben werden. Es zeigt
- FIG 1: das Funktionsprinzip einer Digitalausgabebaugruppe nach dem Stand der Technik,
- FIG 2: das Funktionsprinzip der Digitalausgabebaugruppe nach dem Stand der Technik bei Massebruch,
- FIG 3: eine verbesserte Digitalausgabebaugruppe und
- FIG 4: ein Automatisierungssystem mit einer Digitalausgabebaugruppe.

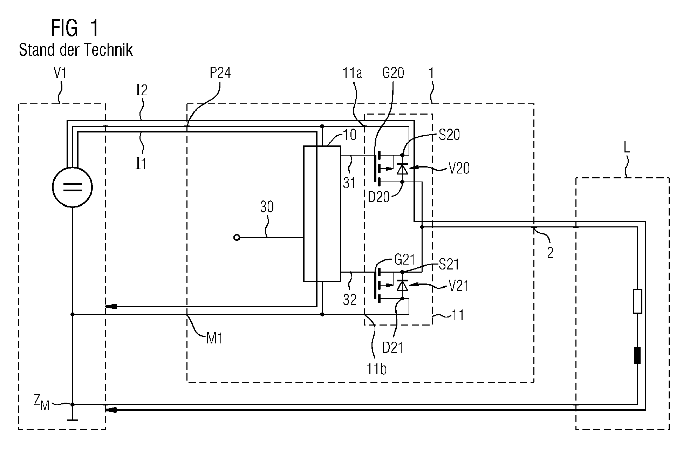

Gemäß der FIG 1 ist eine Digitalausgabebaugruppe 1 nach dem derzeit bekannten Stand der Technik zur Ausgabe digitaler Signale über einen Ansteuerausgang 2 für die Ansteuerung einer Last L dargestellt. Die Digitalausgabebaugruppe 1 ist über einen Versorgungsspannungsanschluss P24 und einem ersten Masseanschluss M1 an einer Spannungsquelle V1 angeschlossen. An den Ansteuerausgang 2 ist eine Last L mit einem ersten Anschluss angeschlossen, wobei ein zweiter Anschluss der Last L an einen zentralen Massepunkt Z_{M}, welcher ebenfalls mit dem Masseanschluss M der Spannungsquelle V1 in Verbindung steht, angeschlossen ist. Die Digitalausgabebaugruppe 1 weist eine Steuerlogik 10 auf, welche zur Versorgung der Steuerlogik 10 mit einer Versorgungsspannung mit dem Versorgungsspannungsanschluss P24 und dem ersten Masseanschluss M1 über jeweils eine Anschlussleitung in Verbindung steht. Die Steuerlogik 10 weist einen ersten Steuerausgang 31 und einen zweiten Steuerausgang 32 auf. Der erste Steuerausgang 31 und der zweite Steuerausgang 32 sind an ein Halbleiterschaltmittel 11 angeschlossen. Als Ausgang weist das Halbleiterschaltmittel 11 den Ansteuerausgang 2 auf. Über den ersten Steuerausgang 31 gibt die Steuerlogik 10 dem Halbleiterschaltmittel 11 einen Schaltbefehl zur Ansteuerung der Last L mit einem High-Pegel vor. Über den zweiten Steuerausgang 32 gibt die Steuerlogik 10 dem Halbleiterschaltmittel 11 einen Steuerbefehl zur Steuerung der Last L mit einem Low-Pegel vor.

Das Halbleiterschaltmittel 11 ist dabei wie folgt ausgestaltet, ein erster Halbleiterschalter V20 ist mit einem Source-Anschluss S20 an dem Versorgungsspannungsanschluss P24 angeschlossen und ein zweiter Halbleiterschalter V21 ist mit einem Drain-Anschluss D21 an dem ersten Masseanschluss M1 angeschlossen. Ein Drain-Anschluss D20 des ersten Halbleiterschalters V20 und ein Source-Anschluss S21 des zweiten Halbleiterschalters V21 ist an dem Ansteuerausgang 2 angeschlossen. Der erste Steuerausgang 31 der Steuerlogik 10 ist an einen Gate-Anschluss G20 des ersten Halbleiterschalters V20 angeschlossen und der zweite Steuerausgang 32 der Steuerlogik 10 ist an einen Gate-Anschluss G21 des zweiten Halbleiterschalters V21 angeschlossen.

Die Steuerlogik 10 ist dabei derart ausgestaltet, dass sie einen über einen Steuereingang 30 kommenden Schaltbefehl zur Ansteuerung des Ansteuerausgangs 2 mit einem High-Pegel oder einem Low-Pegel umsetzt, wobei für einen High-Pegel der erste Steuerausgang 31 den Gate-Anschluss G20 des ersten Halbleiterschalters V20 ansteuert und für einem Low-Pegel der zweite Steuerausgang 32 den Gate-Anschluss G21 des zweiten Halbleiterschalters V21 ansteuert.

Um einen eigenen Verbrauch der Steuerlogik 10 bzw. der elektronischen Komponenten der Baugruppe aufzuzeigen, ist ein erster Strompfad I1 eingezeichnet. Der erste Strompfad I1 startet von der Spannungsquelle V1 über den Versorgungsspannungsanschluss P24 und gelangt über eine entsprechende Zuleitung aus der Steuerlogik 10 heraus zu dem ersten Masseanschluss M1. Der erste Masseanschluss M1 steht wiederum mit einer Masse der ersten Spannungsquelle V1 in Verbindung. Die Steuerlogik 10 ist damit zum Ausführen ihrer Betriebsfunktion an die Spannungsquelle V1 zur Versorgung angeschlossen.

Wird nun das Halbleiterschaltmittel 11 über die Steuerlogik 10 derart angesteuert, dass ein High-Pegel an der Last L ausgegeben werden soll, nämlich der erste Halbleiterschalter V20 wird leitend angesteuert, so bildet sich ein zweiter Strompfad I2 aus. Dieser zweite Strompfad I2 kennzeichnet den Laststrom bei einem High-Pegel. Der zweite Strompfad I2 ist ebenfalls in die Zeichnung eingezeichnet und startet bei der Spannungsquelle V1 und gelangt über den Versorgungsspannungsanschluss P24 in die Digitalausgabebaugruppe 1. Über einen Schaltspannungsanschluss 11a gelangt die Versorgungsspannung der Spannungsquelle V1 an das Halbleiterschaltmittel 11. Der zweite Strompfad I2 kann damit durch das Halbleiterschaltmittel 11 über die Source-Drain-Strecke des ersten Halbleiterschalters V20 an den Ansteuerausgang 2 gelangen. Über den Ansteuerausgang 2 führt der zweite Strompfad I2 über die Last L zu einem zentralen Massepunkt Z_{M}, wobei der zentrale Massepunkt Z_{M} wiederum an die erste Spannungsquelle V1 angeschlossen ist und mit dem ersten Masseanschluss M1 in Verbindung steht.

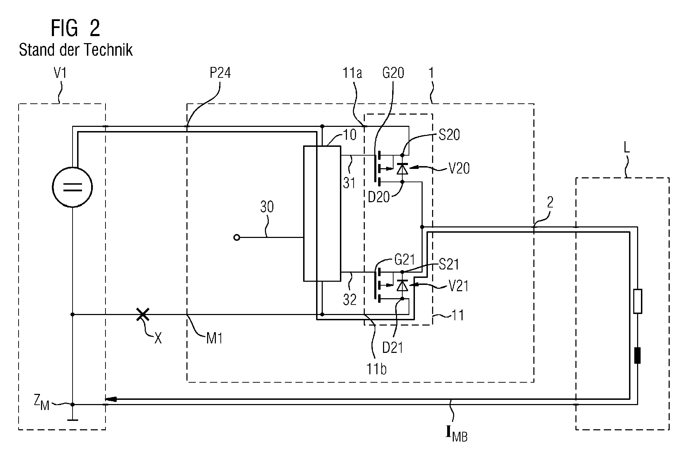

Mit der FIG 2 ist der nach dem Stand der Technik vorherrschende kritische Fall dargestellt, bei einem Massebruch der Masseverbindung zwischen der Masse der Spannungsquelle V1 und dem ersten Masseanschluss M1 der Digitalausgabebaugruppe 1 und einem gleichzeitigen gewollten Ausgeben eines Low-Pegels für die Last L. Der kritische Fall ergibt sich dadurch, dass nun am Ansteuerausgang 2 ein Low-Pegel vorherrschen soll, aber zwischen der Spannungsquelle V1 und dem ersten Masseanschluss M1 eine Unterbrechung X aufgetreten ist. Nun kann sich ein Stromfluss I_{MB} bei Massebruch derart einstellen, dass obwohl die Last L nicht angesteuert werden darf, ca. 20 mA durch die Last L fließen. Der Stromfluss I_{MB} bei Massebruch startet bei der Spannungsquelle V1 geht über den Versorgungsspannungsanschluss P24 in die Digitalausgabebaugruppe 1 herein und fließt über die Steuerlogik 10 zu der internen Versorgungsleitung, welche an den ersten Masseanschluss M1 der Digitalausgabebaugruppe 1 angeschlossen ist, gelangt damit zu dem Drain-Anschluss des zweiten Halbleiterschalters V21 und fließt über den Source-Anschluss S21 zu dem Ansteuerausgang 2 und schließlich über die Last L zu dem zentralen Massepunkt Z_{M}. Dieser Stromfluss I_{MB} bei Massebruch ist nicht gewollt.

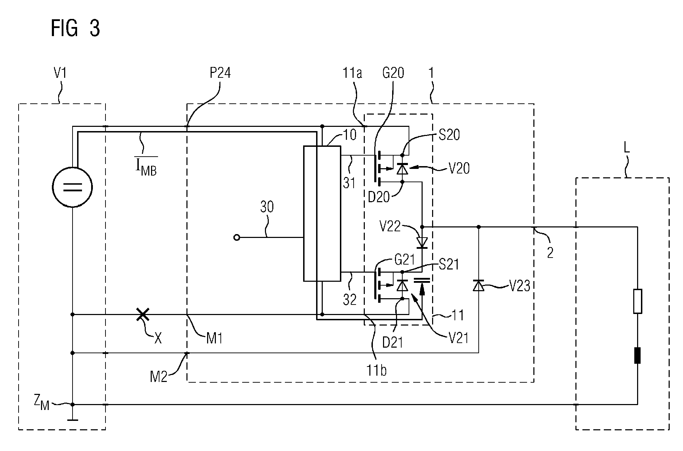

Um einen ungewollten Stromfluss I_{MB} bei einer Unterbrechung X der Verbindung zwischen einer Masse der Spannungsquelle V1 und dem ersten Masseanschluss M1 der Digitalausgabebaugruppe 1 zu unterbinden, ist mit der FIG 3 eine Digitalausgabebaugruppe 1 mit einer Sperrdiode V22 dargestellt. Die Sperrdiode V22 ist zwischen dem zweiten Halbleiterschalter V21 und den Ansteuerausgang 2 angeordnet, die Sperrdiode V22 ist mit ihrer Katode an dem Source-Anschluss S21 des zweiten Halbleiterschaltmittels V21 angeschlossen und mit ihrer Anode an dem Ansteuerausgang 2 angeschlossen. Die Sperrdiode V22 verhindert somit den Stromfluss I_{MB} gemäß FIG 2.

In der FIG 3 ist nun ein unterdrückter Stromfluss ***I̅***_{MB} dargestellt, ein ungewolltes Ausgeben am Ansteuerausgang 2 von beispielsweise 2 mA bei Massebruch ist nun aufgrund der Sperrdiode V22 nicht mehr möglich.

Im Falle einer induktiven Last sollte die induktive Last bei einem Abschalten möglichst gelöscht werden. Hierzu ist in der Digitalausgabebaugruppe 1 ein zweiter Masseanschluss M2 vorgesehen, welcher über die Spannungsquelle V1 mit dem zentralen Massepunkt Z_{M} verbunden ist, und der zweite Masseanschluss M2 ist über eine Freilaufdiode V23 mit dem Ansteuerausgang 2 verbunden, wobei die Freilaufdiode V23 bei einem Low-Pegel am Ansteuerausgang 2 für den Fall, einer induktiven Last in Durchlassrichtung betrieben wird. Bei einer Unterbrechung X der Masseverbindung zwischen der Masse der Spannungsquelle V1 und dem ersten Masseanschluss M1 der Digitalausgabebaugruppe 1 kann sich für das Schalten der Last L immer noch der zweite Strompfad I2 (Laststrom bei High-Pegel) ausbilden, aber der ungewollte Stromfluss I_{MB} bei Massebruch (siehe FIG 2) kann bei der Digitalausgabebaugruppe 1 nach FIG 3 nicht mehr auftreten.

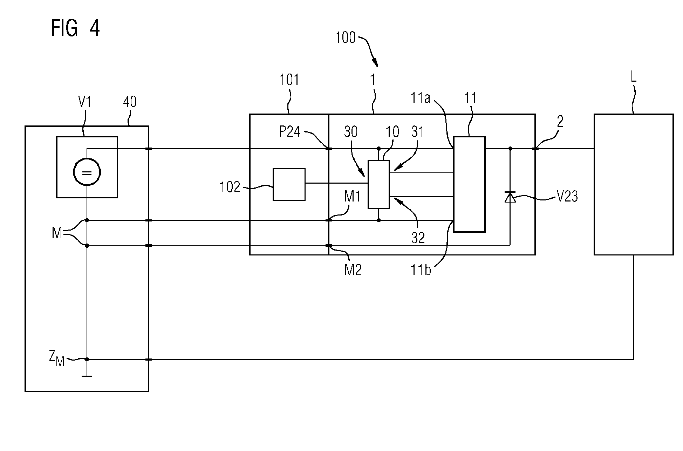

Mit der FIG 4 ist ein Automatisierungssystem 100 dargestellt. Eine Spannungsquelle V1 ist innerhalb eines Schaltschrankes 40 angeordnet. Die Spannungsquelle V1 weist einen 24V-Anschluss und einen Masseanschluss M auf. Der 24V-Anschluss wird durch eine Automatisierungssteuerung 101 an den Versorgungsspannungsanschluss P24 der Digitalausgabebaugruppe 1 geführt. Der Masseanschluss M der Spannungsquelle V1 wird ebenfalls durch die Automatisierungssteuerung 101 an einen ersten Masseanschluss M1 und zusätzlich als separate Leitung an einen zweiten Masseanschluss M2 geführt. Die Automatisierungssteuerung 101 weist einen Mikroprozessor 102 auf, welcher ausgestaltet ist, der Steuerlogik 10 über den Steuereingang 30 Schaltbefehle für das Schalten der Last L mitzuteilen. Die Steuerlogik 10 ist über interne Verbindungsleitungen zum einen mit dem Versorgungsspannungsanschluss P24 und zum anderen mit dem ersten Masseanschluss M1 verbunden. Die Last L ist an dem Ansteuerausgang 2 angeschlossen und an einem zentralen Massepunkt Z_{M}, wobei sich der zentrale Massepunkt Z_{M} meistens innerhalb des Schaltschrankes 40 als eine sogenannte Sammelschiene ausgebildet, befindet.

Durch die in dem Halbleiterschaltmittel 11 bei dem zweiten Halbleiterschalter V21 eingebrachte Sperrdiode V22 kann nun ein Stromfluss bei Massebruch, insbesondere bei Auftrennen der Masseverbindung der Spannungsquelle V1 zu dem ersten Masseanschluss M1 der Digitalausgabebaugruppe 1 nicht mehr auftreten. Im Falle einer induktiven Last L kann über die Freilaufdiode V22 die Last L über den zweiten Masseanschluss M2, welcher ebenfalls in Verbindung mit der Masse M der Spannungsquelle V1 steht, gelöscht werden.

## Patentansprüche

1. Digitalausgabebaugruppe (1) zur Ausgabe digitaler Signale über einen Ansteuerausgang (2) für die Ansteuerung einer Last (L), umfassend
einen Versorgungsspannungsanschluss (P24) und einen ersten Masseanschluss (M1) zum Anschließen einer Spannungsquelle (V1), welche zum einen einen Laststrom für die Last (L) bereitstellt und zum anderen eine Spannungsversorgung für eine Steuerlogik (10) bereitstellt, welche ausgestaltet ist ein Halbleiterschaltmittel (11) zu steuern, und das Halbleiterschaltmittel (11) zur Ansteuerung der Last (L) über den Ansteuerausgang (2) einen ersten Halbleiterschalter (V20) für die Ausgabe eines High-Pegels und einen zweiten Halbleiterschalter (V21) für die Ausgabe eines Low-Pegels aufweist, wobei zwischen dem zweiten Halbleiterschalter (V21) und dem Ansteuerausgang (2) eine Sperrdiode (V22) angeordnet ist, um für den Fall, einer angeschlossenen Last (L) und das ein Low-Pegel am Ansteuerausgang (2) vorherrschen soll, aber aufgrund einer Unterbrechung der über den ersten Masseanschluss (M) hergestellten Masseverbindung zur Spannungsquelle (V1), einen Stromfluss (I_{MB}), ausgehend von der Spannungsquelle (V1) zu dem Versorgungsspannungsanschluss (P24) über die Steuerlogik (10) und über den zweiten Halbleiterschalter (V21) zu dem Ansteuerausgang (2) und weiter über die Last (L) zu einem zentralen Massepunkt (Z_{M}), mit welchem auch die Spannungsquelle (V1) in Verbindung steht, zu unterdrücken.

2. Digitalausgabebaugruppe (1) nach Anspruch 1, mit einem zweiten Masseanschluss (M2), welcher über die Spannungsquelle (V1) mit dem zentralen Massepunkt (Z_{M}) verbunden ist, und der zweite Masseanschluss (M2) über eine Freilaufdiode (V23) mit dem Ansteuerausgang (2) in Verbindung steht, wobei die Freilaufdiode (V23) bei einem Low-Pegel am Ansteuerausgang (2) für den Fall einer induktiven Last (L) in Durchlassrichtung betrieben wird.

3. Digitalausgabebaugruppe (1) nach einem der Ansprüche 1 oder 2, wobei das Halbleiterschaltmittel (11) wie folgt ausgestaltet ist, der erste Halbleiterschalter (V20) ist mit einem Source-Anschluss (S20) an dem Versorgungsspannungsanschluss (P24) und der zweite Halbleiterschalter (V21) ist mit einem Drain-Anschluss (D21) an dem ersten Masseanschluss (M1) angeschlossen, ein Drain-Anschluss (D20) des ersten Halbleiterschalters (V20) und ein Source-Anschluss (S21) des zweiten Halbleiterschalters (V21) ist über die Sperrdiode (V22) an dem Ansteuerausgang (2) angeschlossen, und ein erster Steuerausgang (31) ist an einem Gate-Anschluss (G20) des ersten Halbleiter-Schalters (V20) angeschlossen und ein zweiter Steuereingang (32) ist an einem Gate-Anschluss (G21) des zweiten Halbleiterschalters (V21) angeschlossen,
wobei die Steuerlogik (10) derart ausgestaltet ist, das sie einen über einen Steuereingang (30) kommenden Schaltbefehl zur Ansteuerung des Ansteuerausgangs (2) mit einem High-Pegel oder einem Low-Pegel umsetzt, wobei für einen High-Pegel der erste Steuerausgang (31) den Gate-Anschluss (G20) des ersten Halbleiterschalters (V20) ansteuert und für einen Low-Pegel der zweite Steuerausgang (32) den Gate-Anschluss (G21) des zweiten Halbleiterschalters (V21) ansteuert.

4. Automatisierungssystem (100) aufweisend
eine Spannungsquelle (V1),
eine Automatisierungssteuerung (101),
eine Digitalausgabebaugruppe (1),
eine Last (L),
wobei die Automatisierungssteuerung (101) ausgestaltet ist der Digitalausgabebaugruppe (1) zur Ausgabe digitaler Signale über einen Ansteuerausgang (2) für die Ansteuerung der Last (L) einen Steuerbefehl mitzuteilen,
die Digitalausgabebaugruppe (1) ist über einen Versorgungsspannungsanschluss (P24) und einen ersten Masseanschluss (M) an der Spannungsquelle (V1) angeschlossen,
die Last (L) ist zum einen an dem Ansteuerausgang (2) und zum anderen an einem zentralen Massepunkt (Z_{M}) angeschlossen,
die Digitalausgabebaugruppe (1) weist weiterhin eine Steuerlogik (10) und ein Halbleiterschaltmittel (11) auf, wobei die Steuerlogik (10) ausgestaltet ist das Halbleiterschaltmittel (11) zu steuern, und das Halbleiterschaltmittel (11) ist wiederum ausgestaltet mit einem ersten Halbleiterschalter (V20) für die Ausgabe eines High-Pegels und einem zweiten Halbleiterschalter (V21) für die Ausgabe eines Low-Pegels, wobei zwischen dem zweiten Halbleiterschalter (V21) und dem Ansteuerausgang (2) eine Sperrdiode (V22) angeordnet ist, um für den Fall, einer angeschlossenen Last (L) und das ein Low-Pegel am Ansteuerausgang (2) vorherrschen soll, aber auf Grund einer Unterbrechung (X) der über den ersten Masseanschluss (M1) hergestellten Masseverbindung zur Spannungsquelle (V1), einen Stromfluss (I_{MB}), ausgehend von der Spannungsquelle (V1) zu dem Versorgungsspannungsanschluss (P24) über die Steuerlogik (10) und über den zweiten Halbleiterschalter (V21) zu dem Ansteuerausgang (2) und weiter über die Last (L) zu einem zentralen Massepunkt (Z_{M}), mit welchem auch die Spannungsquelle (V1) in Verbindung steht, zu unterdrücken.

5. Automatisierungssystem (100)) nach Anspruch 4, wobei die Digitalausgabebaugruppe (1) mit einem zweiten Masseanschluss (M2) versehen ist, welcher über die Spannungsquelle (V1) mit dem zentralen Massepunkt (Z_{M}) verbunden ist, und der zweite Masseanschluss (M2) über eine Freilaufdiode (V23) mit dem Ansteuerausgang (2) in Verbindung steht, wobei die Freilaufdiode (V23) bei einem Low-Pegel am Ansteuerausgang (2) für den Fall einer induktiven Last (L) in Durchlassrichtung betrieben wird.
